# EUROPÄISCHE PATENTSCHRIFT

(11) **EP 4 060 376 B1**
(45) Veröffentlichungstag und Bekanntmachung des Hinweises auf die Patenterteilung: **08.05.2024**
(21) Anmeldenummer: 22159467.4
(22) Anmeldetag: 01.03.2022
(51) Int. Cl.: G01S 7/497, G01S 17/931

(54) **TESTSYSTEM FÜR EINEN LIDAR-SENSOR UND VERFAHREN ZUM TESTEN EINES LIDAR-SENSORS**
LIDAR SENSOR TEST SYSTEM AND METHOD FOR TESTING A LIDAR SENSOR
SYSTÈME D'ESSAI POUR UN CAPTEUR LIDAR ET PROCÉDÉ D'ESSAI D'UN CAPTEUR LIDAR

(30) Priorität: 15.03.2021 DE 102021106218
(43) Veröffentlichungstag der Anmeldung: 21.09.2022
(73) Patentinhaber: dSPACE GmbH, 33102 Paderborn (DE)
(72) Erfinder: Sievers, Gregor, 33102 Paderborn (DE); Schütte, Frank, 33102 Paderborn (DE); Hagemeyer, Jens, 33619 Bielefeld (DE); Lachmair, Jan, 33619 Bielefeld (DE); Jungewelter, Dirk, 33619 Bielefeld (DE)

(56) Entgegenhaltungen:
- US-A1- 2011 019 154

## Beschreibung

Die vorliegende Erfindung betrifft ein Testsystem für einen LiDAR-Sensor.

Die vorliegende Erfindung des Weiteren betrifft ein Verfahren zum Testen eines LiDAR-Sensors.

### Stand der Technik

LiDAR (Abkürzung für light detection and ranging) Lichtmesssysteme werden neben weiteren Anwendungen zur optischen Abstands- und Geschwindigkeitsmessung eingesetzt. LiDAR Lichtmesssysteme senden Licht aus und messen die Laufzeit, in der das Licht nach der Reflexion an einem Objekt wieder zum LiDAR Lichtmesssystem zurückkommt. Aus der bekannten Geschwindigkeit des Lichts folgt die Entfernung des Objekts vom LiDAR Lichtmesssystem.

Beispiele für Anwendungsbereiche von LiDAR Lichtmesssystemen sind mobile Instrumente zur optischen Entfernungsmessung und LiDAR Lichtmesssysteme für das Anwendungsfeld Automotive, nämlich Fahrerassistenzsysteme und autonomes Fahren sowie für Aerospace Anwendungen.

DE 102007057372 A1 offenbart ein Testsystem für Lidarsensoren mit einer Triggereinheit, durch welche als Reaktion auf den Empfang eines Signals eines zu testenden Lidarsensors ein Signalgenerator derart angesteuert wird, dass durch eine Signalerzeugungseinheit des Signalgenerators ein vorgegebenes synthetisch erzeugtes oder aufgezeichnetes optisches Signal ausgegeben wird.

DE 102017110790 A1 offenbart eine Simulationsvorrichtung für ein LiDAR - Lichtmesssystem mit einem LiDAR Lichtempfangssensor, wobei in der Ebene des LiDAR - Lichtempfangssensor ein Lichtsender vorhanden ist, wobei ein weiterer Lichtsender neben dem Lichtsender in der Ebene des LiDAR - Lichtempfangssensors angeordnet ist, und wobei ein Rechner die Freischaltung des LiDAR - Lichtempfangssensors und die Zeitspanne zur Abgabe eines Lichtsignals über den Lichtsender und/oder den weiteren Lichtsender überwacht und den Signaleingang des Lichtsignals von dem Lichtsender oder dem weiteren Lichtsender registriert.

US 20110019154 A1 offenbart einen Zielszenengenerator für ein bildgebendes LADAR-System. Der Generator umfasst dabei ein Pixelarray, einen Photodetektor zur Detektion einfallenden Lichts ausgehend vom zu testenden LADAR-System, und ein rekonfigurierbares System aus Faseroptiken. Außerdem ist ein Schalternetzwerk umfasst, welches das faseroptische System konfiguriert, um generatorseitige Lichtquellen selektiv in das Pixelarray einzukoppeln.

Ein Problem bei dem Testen von Lidarsensoren unter Verwendung eines Signalgenerators besteht darin, dass die Pixelauflösung einer Signalerzeugungseinheit eines Signalgenerators herkömmlicherweise sehr gering ist. Somit sind komplexe Szenen mit einer Mehrzahl von Objekten unterschiedlicher Entfernungen sowie unterschiedlicher Intensitäten nicht detailgetreu simulierbar.

Es ist daher Aufgabe der Erfindung, bestehende Vorrichtungen und Verfahren zum Testen eines LiDAR-Sensors dahingehend zu verbessern, dass diese eine detailgetreue Simulation bei gleichzeitig effizienter Nutzung von Hardwareressourcen ermöglichen.

### Offenbarung der Erfindung

Die Aufgabe wird erfindungsgemäß durch ein Testsystem für einen LiDAR-Sensor mit den Merkmalen des Patentanspruchs 1 gelöst.

Die Aufgabe wird erfindungsgemäß ferner durch ein Verfahren zum Testen eines LiDAR-Sensors mit den Merkmalen des Patentanspruchs 11 gelöst. Die Erfindung betrifft ein Testsystem für einen LiDAR-Sensor. Das Testsystem umfasst einem Trigger-Detektor und einem mit dem Trigger-Detektor verbundenen Signalgenerator.

Durch den Trigger-Detektor wird in Reaktion auf den Empfang eines Triggersignals eines zu testenden LiDAR-Sensors der Signalgenerator derart angesteuert, dass durch eine Signalerzeugungseinheit des Signalgenerators ein vorgegebenes, synthetisch erzeugtes, optisches Signal, insbesondere eine synthetisch erzeugte Reflexion des Triggersignals, ausgegeben wird.

Die Signalerzeugungseinheit weist eine Anzeigefläche mit einer vorgegebenen Anzahl von Pixeln auf. Der Signalgenerator ist ferner dazu eingerichtet, Pixel gleicher Intensität zu einem Cluster zu aggregieren.

Die Erfindung betrifft des Weiteren ein Verfahren zum Testen eines LiDAR-Sensors. Das Verfahren umfasst ein Bereitstellen eines Trigger-Detektors und eines mit dem Trigger-Detektor verbundenen Signalgenerators.

Darüber hinaus umfasst das Verfahren ein Bereitstellen einer Anzeigefläche einer Signalerzeugungseinheit des Signalgenerators mit einer vorgegebenen Anzahl von Pixeln.

Des Weiteren umfasst das Verfahren ein Ansteuern des Signalgenerators durch den Trigger-Detektor in Reaktion auf den Empfang eines Signals eines zu testenden LiDAR-Sensors derart, dass durch die Signalerzeugungseinheit des Signalgenerators ein vorgegebenes, synthetisch erzeugtes, optisches Signal, insbesondere eine synthetisch erzeugte Reflexion eines LiDAR-Sensorsignals, ausgegeben wird.

Das Verfahren umfasst ferner ein Aggregieren von Pixeln gleicher Intensität zu einem Cluster durch den Signalgenerator.

Eine Idee der vorliegenden Erfindung ist es LiDAR Over-the-Air (OTA) Pixel einer Anzeigefläche, d.h. Emitter bzw. Lichtsendeeinheiten des OTA Testsystems dynamisch verschiedenen Intensitäten zuzuordnen, d.h. zu Gruppen verschiedener Intensitäten zu aggregieren. Es gelingt somit, eine größere Anzahl Pixel pro Steuerungschip anzuschließen als Intensitätselemente, d.h. Digital-Analog-Wandler existieren.

Gerade die Anzahl der Intensitätselemente und vor allem die Ansteuerung derselben ist ein limitierender Faktor bei der Umsetzung von LiDAR Over-the-Air Testsystemen. Durch die dynamische Aggregation von LiDAR OTA Pixeln zu Gruppen mit gleicher Intensität kann damit die Integrationsdichte des Gesamtsystems bei gleichzeitiger Kostenersparnis deutlich erhöht werden.

Bereiche mit höherer Auflösungsanforderung und vielen dazustellenden Objekten können mit vielen Pixeln einzeln kontrollierbar dargestellt werden (bspw. Fahrbahnrand mit Autos, Bäumen und Personen). Die verfügbaren Intensitätsressourcen können somit dynamisch diesen Bereichen zugeordnet werden.

Bereiche mit geringen Auflösungsanforderungen werden dann mit verringerter Auflösung dargestellt, z.B. eine größere Fläche mit identischem Reflexionsverhalten wie ein Aufbau eines LKW-Anhängers, oder Reflexionen von weit entfernten Objekten, die durch die geringen Lichtquanten, die am Sensor ankommen vom Sensor in Ihrer Intensität nicht mehr voneinander unterschieden werden können. Diese

Auflösungsanforderung kann je Szene mit ausreichender Änderungsrate angepasst werden, d.h. die LiDAR Pixel des Testsytems können dynamisch aggregiert werden.

Ein Cluster bzw. Pixel Aggregation Cluster (PAC) fasst daher einen Teilbildbereich zusammen. In diesem Teilbereich können für Pixel mit gleichen Distanzen einheitliche Intensitäten erzeugt werden, wobei die Intensität der Pixel für andere Distanzen innerhalb einer Szene geändert werden kann (bspw. für hintereinander liegende, teilverdeckte Objekte). Zusätzlich kann jedes der Pixel eines Teilbereichs für jede Distanz wahlweise ausgeschaltet bleiben um unterschiedliche Objektformen für unterschiedliche Distanzen zu gewährleisten.

Weitere Ausführungsformen der vorliegenden Erfindung sind Gegenstand der weiteren Unteransprüche und der nachfolgenden Beschreibung unter Bezugnahme auf die Figuren.

Erfindungsgemäß ist vorgesehen, dass der Signalgenerator eine Mehrzahl von Leiterplatten aufweist, auf denen jeweils eine Mehrzahl von Digital-Analog-Wandlern angeordnet sind, wobei jeder der Mehrzahl von Digital-Analog-Wandlern mit einem Eingang einer Mehrzahl von Crosspoint-Schaltern verbunden ist.

Durch die Verschaltung der Digital-Analog-Wandler mit den Crosspoint-Schaltern einer jeweiligen Leiterplatte können in vorteilhafter Weise eine größere Anzahl Pixel pro Steuerungschip angeschlossen werden als Intensitätselemente, d.h. Digital-Analog-Wandler existieren.

Gemäß der Erfindung ist vorgesehen, dass jeweilige Ausgänge der Mehrzahl von Crosspoint-Schaltern mit einem ein Leuchtelement der Signalerzeugungseinheit, insbesondere eine Leuchtdiode oder eine Laserdiode, ansteuernden Leuchtelement-Treiber verbunden sind.

Jeder Crosspoint Schalter kann somit in vorteilhafter Weise eine Mehrzahl von Leuchtelement-Treibern ansteuern. Gemäß einer weiteren bevorzugten Weiterbildung der Erfindung ist vorgesehen, dass jeweilige Leuchtelemente der Signalerzeugungseinheit jeder der Mehrzahl von Leiterplatten über Lichtwellenleiter mit einem dem jeweiligen Leuchtelement zugeordneten Pixel der Anzeigefläche verbunden sind.

Somit können die Leuchtelemente auf der Leiterplatte in vorteilhafter Weise so nahe wie möglich an den Leuchtelemente-Treibern angeordnet werden.

Gemäß der Erfindung ist vorgesehen, dass die Anzahl von Leuchtelementen jeder Leiterplatte größer als die Anzahl von Digital-Analog-Wandlern ist, wobei die zwischen den Digital-Analog-Wandlern und den Leuchtelement-Treibern der Leuchtelemente angeordneten Crosspoint-Schalter dazu ausgebildet sind, eine dynamisch einstellbare, koordinatenweise Verbindung zwischen den Digital-Analog-Wandlern und den Leuchtelementen bereitzustellen.

Dadurch können auf der Anzeigefläche eine Mehrzahl von Pixeln zu Clustern aggregiert werden.

Gemäß einer weiteren bevorzugten Weiterbildung der Erfindung ist vorgesehen, dass die Mehrzahl von, auf einer jeweiligen Leiterplatte angeordneten Digital-Analog-Wandlern durch einen auf der jeweiligen Leiterplatte oder außerhalb der jeweiligen Leiterplatte angeordneten integrierten Schaltkreis, insbesondere einen FPGA, ansteuerbar sind.

Das FPGA steuert somit in vorteilhafter Weise die Aggregation von Pixeln zu Clustern auf der Anzeigefläche der Signalerzeugungseinheit.

Gemäß einer weiteren bevorzugten Weiterbildung der Erfindung ist vorgesehen, dass der integrierte Schaltkreis, insbesondere das FPGA, mit einem Eingang jedes der Mehrzahl von Digital-Analog-Wandlern verbunden ist.

Somit sind durch den FPGA in vorteilhafter Weise sämtliche Digital-Analog-Wandler der jeweiligen Leiterplatte einzeln steuerbar.

Gemäß einer weiteren bevorzugten Weiterbildung der Erfindung ist vorgesehen, dass der aggregierte Cluster von Pixeln gleicher Intensitäten unabhängig von einer Form und/oder einer zeitlichen Verzögerung von innerhalb eines Messzyklus des zu testenden LiDAR-Sensors auf der Anzeigefläche dargestellten Objekten ist, und wobei die zu dem Cluster aggregierten Pixel Leuchtelementen einer Mehrzahl von Leiterplatten zuordbar sind.

Die aggregierten Cluster sind somit flexibel an die auf der Anzeigefläche dargestellten Objekte anpassbar.

Gemäß einer weiteren bevorzugten Weiterbildung der Erfindung ist vorgesehen, dass jeder Eingang eines Crosspoint-Schalters auf eine Mehrzahl von Ausgängen des Crosspoint-Schalters aufschaltbar ist, wobei jeder Digital-Analog-Wandler dazu eingerichtet ist, jedes Leuchtelement anzusteuern.

Damit können in vorteilhafter Weise eine Mehrzahl von Leuchtelementen bzw. den zugeordneten Pixeln durch die entsprechenden Digital-Analog-Wandler zu Clustern aggregiert werden.

Gemäß einer weiteren bevorzugten Weiterbildung der Erfindung ist vorgesehen, dass jeder auf der Anzeigefläche der Signalerzeugungseinheit erzeugte Cluster von Messzyklus zu Messzyklus des zu testenden LiDAR-Sensors in dessen Größe und Positionierung auf der Anzeigefläche der Signalerzeugungseinheit anpassbar ist.

Die auf der Anzeigefläche dargestellten Cluster können somit von Frame zu Frame an jeweilige Änderungen der simulierten Szene angepasst werden.

Gemäß einer weiteren bevorzugten Weiterbildung der Erfindung ist vorgesehen, dass ein auf der Anzeigefläche der Signalerzeugungseinheit dargestelltes Objekt in eine Mehrzahl von Cluster aufteilbar ist, und wobei die Anzeigefläche der Signalerzeugungseinheit eine mit einem vorgegebenen Radius gekrümmte Fläche aufweist.

Die PAC's haben dabei grundsätzlich keine Bindung an die Objektgestalt. Vielmehr werden - je nach Auflösungsanforderung - Pixel, die in gleicher Distanz auch gleiche Intensität haben, zusammengefasst. Ein PAC kann auch mehrere dieser Gruppen, die sich z.B. durch unterschiedliche Distanzen unterscheiden, zusammenfassen. Durch die AN/AUS-Schalter der Pixel wird in Distanz-Richtung zwischen diesen Gruppen unterschieden.

Die Krümmung der Anzeigefläche ermöglicht in vorteilhafter Weise eine verbesserte bzw. einer realen Szene entsprechende Objektsimulation.

Gemäß einer weiteren bevorzugten Weiterbildung der Erfindung ist vorgesehen, dass auf der Anzeigefläche der Signalerzeugungseinheit in einem Messzyklus dargestellte, unterschiedliche Intensitäten aufweisende und hintereinander liegende, überlappende Objekte zu einem Cluster aggregierbar sind, wobei zwischen den Objekten bestehende Abstände durch Ausschalten der Pixel für eine vorgegebene Zeitdauer darstellbar sind.

Somit können in vorteilhafter Weise hintereinander liegende Objekte auf der zweidimensionalen Anzeigefläche dargestellt werden.

Gemäß einer weiteren bevorzugten Weiterbildung der Erfindung ist vorgesehen, dass eine Pixelauflösung und/oder eine Anzahl darstellbarer Intensitätsabstufungen der Anzeigefläche der Signalerzeugungseinheit zumindest einer Pixelauflösung und/oder einer Anzahl erfassbarer Intensitätsabstufungen des LiDAR-Sensors entspricht.

Die zu simulierende Szene kann somit mit einer vollen von dem LiDAR-Sensor unterstützten Pixelauflösung und/oder darstellbarer Intensitätsabstufung auf der Anzeigefläche dargestellt werden.

Die hierin beschriebenen Merkmale des Testsystems für einen LiDAR-Sensor sind ebenfalls auf das Verfahren zum Testen eines LiDAR-Sensors und umgekehrt anwendbar.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: eine schematische Darstellung eines Testsystems für einen LiDAR-Sensor gemäß einer bevorzugten Ausführungsform der Erfindung;
- Fig. 2: eine schematische Darstellung eines Abschnitts des Testsystems für den LiDAR-Sensor gemäß der bevorzugten Ausführungsform der Erfindung;
- Fig. 3: eine schematische Darstellung einer Anzeigefläche einer Signalerzeugungseinheit gemäß der bevorzugten Ausführungsform der Erfindung; und
- Fig. 4: ein Ablaufdiagramm eines Verfahrens zum Testen des LiDAR-Sensors gemäß der bevorzugten Ausführungsform der Erfindung;

Sofern nicht anders angegeben, bezeichnen gleiche Bezugszeichen gleiche Elemente der Zeichnungen.

### Ausführliche Beschreibung der Ausführungsformen

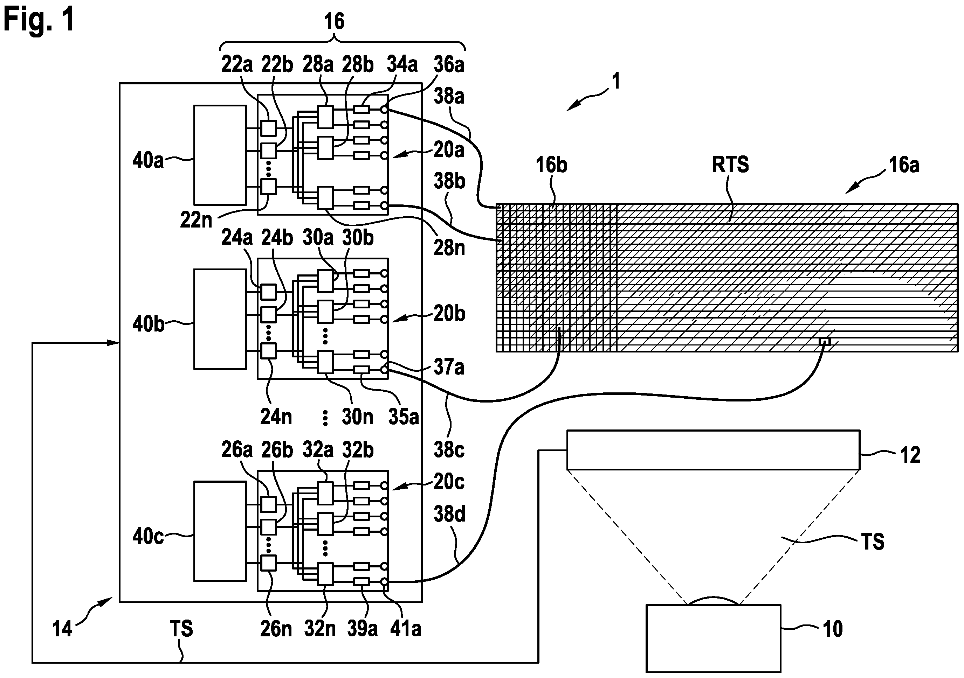

Das in Fig. 1 gezeigte Testsystem umfasst einen Trigger-Detektor 12 und einem mit dem Trigger-Detektor 12 verbundenen Signalgenerator 14, wobei durch den Trigger-Detektor 12 in Reaktion auf den Empfang eines Triggersignals TS eines zu testenden LiDAR-Sensors 10 der Signalgenerator 14 derart angesteuert wird, dass durch eine Signalerzeugungseinheit 16 des Signalgenerators 14 ein vorgegebenes, synthetisch erzeugtes, optisches Signal RTS, insbesondere eine synthetisch erzeugte Reflexion des Triggersignals TS, ausgegeben wird.

Der LiDAR-Sensor 12 ist als Flash-LiDAR ausgebildet. Alternativ kann der LiDAR-Sensor 12 beispielsweise durch ein mechanisch abtastendes LiDAR ausgebildet sein.

Die Signalerzeugungseinheit 16 weist eine Anzeigefläche 16a mit einer vorgegebenen Anzahl von Pixeln 16b auf. Ferner ist der Signalgenerator 14 dazu eingerichtet, Pixel 16b gleicher Intensität I zu einem Cluster 18 zu aggregieren. Die synthetische Szene wird dabei durch eine Recheneinrichtung, z.B. einen PC, in den Signalgenerator 14 eingespeist.

Der Signalgenerator 14 weist eine Mehrzahl von Leiterplatten 20a, 20b, 20c auf, auf denen jeweils eine Mehrzahl von Digital-Analog-Wandlern 22a-22n, 24a-n, 26an angeordnet sind. Jeder der Mehrzahl von Digital-Analog-Wandlern 22a-22n, 24a-n, 26a-n ist dabei mit einem Eingang einer Mehrzahl von Crosspoint-Schaltern 28a-n, 30a-n, 32a-n verbunden.

Jeweilige Ausgänge der Mehrzahl von Crosspoint-Schaltern 28a-n, 30a-n, 32a-n sind mit einem ein Leuchtelement 36a-z, 37a, 41a der Signalerzeugungseinheit 16, insbesondere eine Leuchtdiode oder eine Laserdiode, ansteuernden Leuchtelement-Treiber 34a-z, 35a, 39a verbunden.

Jeweilige Leuchtelemente 36a-z, 37a, 41a der Signalerzeugungseinheit 16 jeder der Mehrzahl von Leiterplatten 20a, 20b, 20c sind über Lichtwellenleiter 38a, 38b, 38c, 38d mit einem dem jeweiligen Leuchtelement 36a-z, 37a, 41a zugeordneten Pixel 16b der Anzeigefläche 16a verbunden.

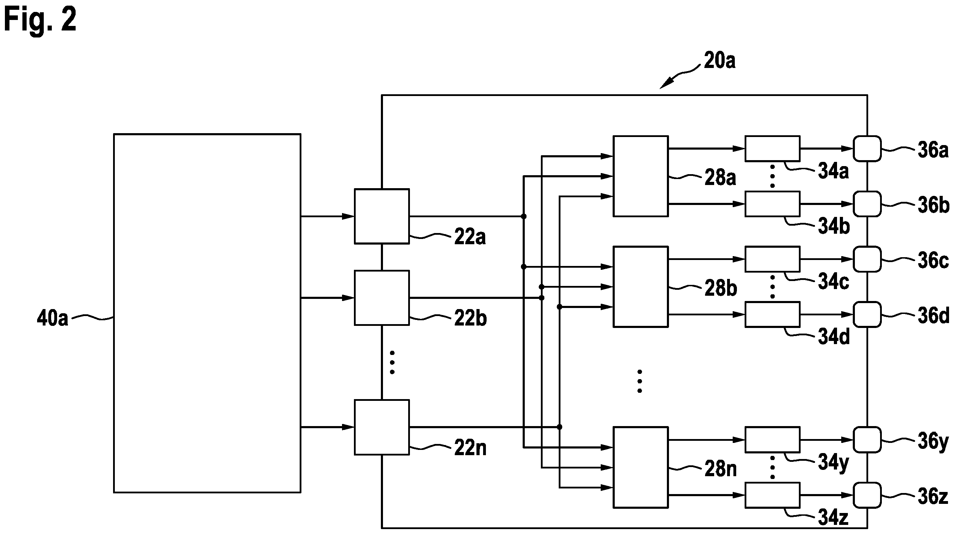

Fig. 2 zeigt eine schematische Darstellung eines Abschnitts des Testsystems für den LiDAR-Sensor gemäß der bevorzugten Ausführungsform der Erfindung.

Die Anzahl von Leuchtelementen 36a-z der Leiterplatte 20a ist größer als die Anzahl von Digital-Analog-Wandlern 22a-22n. Die zwischen den Digital-Analog-Wandlern 22a-22n und den Leuchtelement-Treibern 34a-z der Leuchtelemente 36a-z angeordneten Crosspoint-Schalter 28a-n sind des Weiteren dazu ausgebildet, eine dynamisch einstellbare, koordinatenweise Verbindung zwischen den Digital-Analog-Wandlern 22a-22n und den Leuchtelementen 36a-z bereitzustellen.

Die Mehrzahl von, auf der Leiterplatte 20a angeordneten Digital-Analog-Wandlern 22a-22n sind durch einen außerhalb der Leiterplatte 20a angeordneten integrierten Schaltkreis 40a, insbesondere ein Field-Programmable-Gate-Array (FPGA), ansteuerbar.

Alternativ können die Mehrzahl von, auf der Leiterplatte 20a angeordneten Digital-Analog-Wandlern 22a-22n durch einen beispielsweise auf der Leiterplatte 20a angeordneten integrierten Schaltkreis 40a insbesondere einen FPGA, ansteuerbar sein.

Jeder Eingang eines Crosspoint-Schalters 28a-n ist dabei auf eine Mehrzahl von Ausgängen des Crosspoint-Schalters 28a-n aufschaltbar.

Jeder Digital-Analog-Wandler 22a-22n ist dazu eingerichtet, jedes Leuchtelement 36a-z anzusteuern.

Die Steuerung, welche Pixel zu welchem Zeitpunkt und welcher Intensität aktiv sein sollen, wird dabei in dem integrierten Schaltkreis, insbesondere dem FPGA umgesetzt. Dabei wird das entsprechende digitale Signal der durch die Recheneinrichtung erzeugten Umgebungssimulation zunächst in ein analoges Signal gewandelt und dann als Eingangssignal für den Leuchtmitteltreiber 34a-z verwendet.

Die Erfindung beruht auf der Erkenntnis, dass gar nicht so viele verschiedene Intensitätswerte verwendet werden müssen, als Sensorpixel existieren. Das Ziel der Pixelwand bzw. Anzeigefläche 16a ist es, eine Punktwolke nachzuahmen, welche der LIDAR-Sensor 10 im echten Einsatz sieht.

Bei Betrachtung einer Punktwolke als zu erreichendes Simulationsergebnis ergibt sich die Erkenntnis, dass nur eine begrenzte Anzahl verschiedener Intensitätswerte abgebildet werden müssen.

Ein Cluster 18 bzw. Pixel-Aggregation-Cluster definiert sich durch die zu einem Intensitätscluster gehörenden Leuchtelemente 36a-z.

Global betrachtet können damit auch mehrere Digital-Analog-Wandler 22a-22n pro Cluster 18 denselben Intensitätswert liefern. Das läuft dann darauf hinaus, dass theoretisch die gesamte Anzeigefläche ein großes Cluster 18 sein kann.

Ein Cluster 18 muss aber nichts mit der Form eines Objektes zu tun haben. Die zugehörigen Leuchtelemente können irgendwo liegen, sie müssen nur bei der Einspeisung der Szene zum gleichen Zeitpunkt den gleichen Intensitätswert aufweisen.

Die Signalerzeugseinheit 16 ist dabei so ausgelegt, dass der Intensitätswert der aggregierten Pixel von Distanz zu Distanz geändert werden kann. Für eine Unterauswahl der Pixel zu einer Distanz sind Pixel Enable-Signale vorgesehen. Die Cluster 18 werden von Szene zu Szene bzw. von Frame zu Frame der Umgebungssimulation neu definiert.

Zu einem Zeitpunkt, also einem Abstand zum Sensor hat man zwar nur soviele Intensitäten wie Digital-Analog-Wandler-Kanäle, allerdings lassen sich diese dann beliebig wählen. Auch wenn insgesamt nur wenig Intensitäten zur Verfügung stehen, reichen diese in der Regel aus.

Vorteilhaft ist, dass bestimmte Bereiche höher aufgelöst werden können, d.h. mehr Intensitäten pro Pixelfläche aufweisen, wobei andere Bereiche geringer aufgelöst werden. Diese Zuordnung kann dynamisch von Szene zu Szene variiert werden.

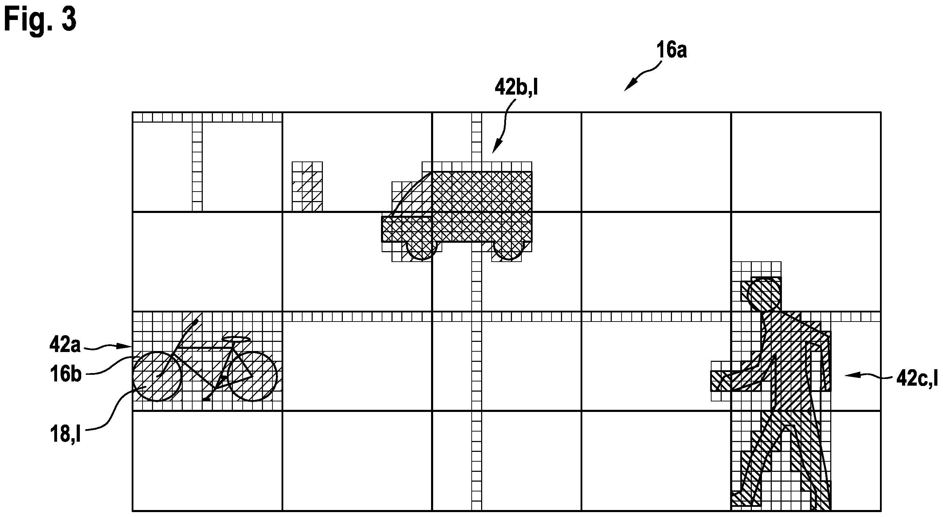

Fig. 3 zeigt eine schematische Darstellung einer Anzeigefläche einer Signalerzeugungseinheit gemäß der bevorzugten Ausführungsform der Erfindung.

Der aggregierte Cluster 18 von Pixeln 16b gleicher Intensität I ist unabhängig von einer Form und/oder einer zeitlichen Verzögerung von innerhalb eines Messzyklus des zu testenden LiDAR-Sensors 10 auf der Anzeigefläche 16a dargestellten Objekten 42a, 42b, 42c.

Des Weiteren sind die zu dem Cluster 18 aggregierten Pixel 16b Leuchtelementen 36a-z, 37a, 41a einer Mehrzahl von Leiterplatten 20a, 20b, 20c zuordbar. Jeder auf der Anzeigefläche 16a der Signalerzeugungseinheit 16 erzeugte Cluster 18 ist hierbei von Messzyklus zu Messyklus des zu testenden LiDAR-Sensors 10 in dessen Größe und Positionierung auf der Anzeigefläche 16a der Signalerzeugungseinheit 16 anpassbar.

Ein auf der Anzeigefläche 16a der Signalerzeugungseinheit 16 dargestelltes Objekt 42a, 42b, 42c ist in eine Mehrzahl von Clustern 18 aufteilbar.

Die Anzeigefläche 16a der Signalerzeugungseinheit 16 weist vorzugsweise eine planare Oberfläche auf.

Alternativ kann die Anzeigefläche 16a der Signalerzeugungseinheit 16 eine mit einem vorgegebenen Radius gekrümmte Fläche aufweisen.

Auf der Anzeigefläche 16a der Signalerzeugungseinheit 16 in einem Messzyklus dargestellte, unterschiedliche Intensitäten I aufweisende und hintereinander liegende, überlappende Objekte 42a, 42b, 42c sind zu einem Cluster 18 aggregierbar. Zwischen den Objekten 42a, 42b, 42c bestehende Abstände sind durch Ausschalten der Pixel 16b für eine vorgegebene Zeitdauer darstellbar.

Eine Pixelauflösung und/oder eine Anzahl darstellbarer Intensitätsabstufungen der Anzeigefläche 16a der Signalerzeugungseinheit 16 entspricht dabei zumindest einer Pixelauflösung und/oder einer Anzahl erfassbarer Intensitätsabstufungen des LiDAR-Sensors 10.

Unterschiedliche Intensitäten können entweder von Distanz zu Distanz oder von Cluster 18 zu Cluster 18 erzeugt werden. Ein durch eine Leiterplatte ansteuerbare Pixelbereich der Anzeigefläche 16a ist als ein schwarzer Rahmen gekennzeichnet. Am Beispiel des Fußgängers im vorderen rechten Bildbereich als Target und einer Überlappung des Targets über mehrere Leiterplatten lässt sich die Funktionsweise erkennen.

Der Kopf hat eine mittel hohe, der Körper eine hohe, die Beine eine mittlere und die Hand eine geringe Intensität. Die Intensität hängt mit der Reflektivität der Target-Oberfläche und der Entfernung zum Sensor zusammen.

Auch der LKW kann je nach Position im Bildbereich gut dargestellt werden, indem das obere verglaste Fahrerhaus vom Rest des LKW mit metallisch hoher Reflektivität abgegrenzt werden kann.

Der untere Teil des LKW's ist dabei ein Cluster 18 gleicher Intensität und erstreckt sich über zwei Leiterplatten.

Die Abbildung der simulierten Distanz eines Objekts wird durch die zeitliche Verzögerung des Signals, welches die Pixel ausstrahlen, abgebildet. In einer Szene können also Objekte mit unterschiedlichen Abständen vorkommen, die dann zu unterschiedlichen Zeitpunkten durch die Pixelwand 16a dargestellt werden.

Die Intensitätswerte können zwischen den verschiedenen Distanzen noch verändert werden, oder es können Pixel durch Enable-Signale ausgeschaltet werden. Wegen der langen Schaltzeiten der Crosspoint-Switches 28a-n, 30a-n, 32a-n kann eine Veränderung der Cluster 18 nur nach jedem Messzyklus des Sensors 10 stattfinden. Im Rahmen dieser Restriktionen können also auch hintereinander liegende Objekte mit unterschiedlichen Distanzen zum Sensor 10 mit denselben Pixeln 16b dargestellt werden.

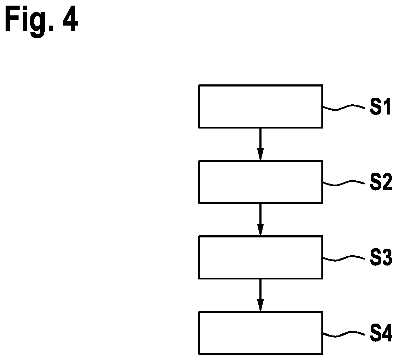

Fig. 4 zeigt ein Ablaufdiagramm eines Verfahrens zum Testen des LiDAR-Sensors gemäß der bevorzugten Ausführungsform der Erfindung.

Das Verfahren umfasst ein Bereitstellen S1 eines Trigger-Detektors 12 und eines mit dem Trigger-Detektor 12 verbundenen Signalgenerators 14.

Des Weiteren umfasst das Verfahren ein Bereitstellen S2 einer Anzeigefläche 16a einer Signalerzeugungseinheit 16 des Signalgenerators 14 mit einer vorgegebenen Anzahl von Pixeln 16b.

Das Verfahren umfasst ferner ein Ansteuern S3 des Signalgenerators 14 durch den Trigger-Detektor 12 in Reaktion auf den Empfang eines Signals eines zu testenden LiDAR-Sensors 10 derart, dass durch die Signalerzeugungseinheit 16 des Signalgenerators 14 ein vorgegebenes, durch eine Recheneinrichtung synthetisch erzeugtes, optisches Signal, insbesondere eine synthetisch erzeugte Reflexion eines LiDAR-Sensorsignals, ausgegeben wird.

Darüber hinaus umfasst das Verfahren ein Aggregieren S4 von Pixeln 16b gleicher Intensität I zu einem Cluster 18 durch den Signalgenerator 14.

Obwohl hierin spezifische Ausführungsformen illustriert und beschrieben wurden, ist es dem Fachmann verständlich, dass eine Vielzahl von alternativen und/oder äquivalenten Implementierungen existieren. Es sollte beachtet werden, dass die beispielhafte Ausführungsform oder beispielhaften Ausführungsformen nur Beispiele sind und nicht dazu dienen, den Umfang, die Anwendbarkeit oder die Konfiguration in irgendeiner Weise einzuschränken.

Vielmehr liefert die vorstehend genannte Zusammenfassung und ausführliche Beschreibung dem Fachmann eine bequeme Anleitung zur Implementierung zumindest einer beispielhaften Ausführungsform, wobei verständlich ist, dass verschiedene Änderungen im Funktionsumfang und der Anordnung der Elemente vorgenommen werden können, ohne vom Umfang der beigefügten Ansprüche und ihrer rechtlichen Äquivalente abzuweichen.

Im Allgemeinen beabsichtigt diese Anmeldung, Änderungen bzw. Anpassungen oder Variationen der hierin dargestellten Ausführungsformen abzudecken.

Der LiDAR-Sensor kann beispielsweise durch ein mechanisch-rotierend abtastendes LiDAR ausgebildet sein. In diesem Fall wäre die Anzeigefläche 16a der Signalerzeugungseinheit 16 in einem Winkel von 360° um den LiDAR-Sensor 12 herum angeordnet.

### Bezugszeichenliste

- 1: Testsystem
- 10: LiDAR-Sensor
- 12: Trigger-Detektor
- 14: Signalgenerator
- 16: Signalerzeugungseinheit
- 18: Cluster
- 16a: Anzeigefläche
- 16b: Pixel
- 20a,20b, 20c: Leiterplatten
- 22a-n: Digital-Analog-Wandler
- 24a-n: Digital-Analog-Wandler
- 26a-n: Digital-Analog-Wandler
- 28a-n: Crosspoint-Schalter
- 30a-n: Crosspoint-Schalter
- 32a-n: Crosspoint-Schalter
- 34a-z, 35a, 39a: Leuchtelement-Treiber
- 36a-z, 37a, 41a: Leuchtelemente
- 38a, 38b, 38c, 38d: Lichtwellenleiter
- 40a, 40b, 40c: integrierter Schaltkreis
- 42a, 42b, 42c: Objekt
- I: Intensität
- RTS: optisches Signal
- S1-S4: Verfahrensschritte
- TS: Triggersignal

## Patentansprüche

1. Testsystem (1) für einen LiDAR-Sensor (10), mit einem Trigger-Detektor (12) und einem mit dem Trigger-Detektor (12) verbundenen Signalgenerator (14), wobei durch den Trigger-Detektor (12) in Reaktion auf den Empfang eines Triggersignals (TS) eines zu testenden LiDAR-Sensors (10) der Signalgenerator (14) derart angesteuert wird, dass durch eine Signalerzeugungseinheit (16) des Signalgenerators (14) ein vorgegebenes, synthetisch erzeugtes, optisches Signal (RTS), insbesondere eine synthetisch erzeugte Reflexion des Triggersignals (TS), ausgegeben wird, wobei die Signalerzeugungseinheit (16) eine Anzeigefläche (16a) mit einer vorgegebenen Anzahl von Pixeln (16b) aufweist, und wobei der Signalgenerator (14) dazu eingerichtet ist, Pixel (16b) gleicher Intensität (I) zu einem Cluster (18) zu aggregieren, **dadurch gekennzeichnet dass** der Signalgenerator (14) eine Mehrzahl von Leiterplatten (20a, 20b, 20c) aufweist, auf denen jeweils eine Mehrzahl von Digital-Analog-Wandlern (22a-22n, 24a-n, 26a-n) angeordnet sind, wobei jeder der Mehrzahl von Digital-Analog-Wandlern (22a-22n, 24a-n, 26a-n) mit einem Eingang einer Mehrzahl von Crosspoint-Schaltern (28a-n, 30a-n, 32a-n) verbunden ist, wobei jeweilige Ausgänge der Mehrzahl von Crosspoint-Schaltern (28a-n, 30a-n, 32a-n) mit einem ein Leuchtelement (36a-z, 37a, 41a) der Signalerzeugungseinheit (16), insbesondere eine Leuchtdiode oder eine Laserdiode, ansteuernden Leuchtelement-Treiber (34a-z, 35a, 39a) verbunden sind, wobei die Anzahl von Leuchtelementen (36a-z, 37a, 41a) jeder Leiterplatte (20a, 20b, 20c) größer als die Anzahl von Digital-Analog-Wandlern (22a-22n, 24a-n, 26a-n) ist, wobei die zwischen den Digital-Analog-Wandlern (22a-22n, 24a-n, 26a-n) und den Leuchtelement-Treibern (34a-z, 35a, 39a) der Leuchtelemente (36a-z, 37a, 41a) angeordneten Crosspoint-Schalter (28a-n, 30a-n, 32a-n) dazu ausgebildet sind, eine dynamisch einstellbare, koordinatenweise Verbindung zwischen den Digital-Analog-Wandlern (22a-22n, 24a-n, 26a-n) und den Leuchtelementen (36a-z, 37a, 41a) bereitzustellen.

2. Testsystem nach Anspruch 1, wobei jeweilige Leuchtelemente (36a-z, 37a, 41a) der Signalerzeugungseinheit (16) jeder der Mehrzahl von Leiterplatten (20a, 20b, 20c) über Lichtwellenleiter (38a, 38b, 38c, 38d) mit einem dem jeweiligen Leuchtelement (36a-z, 37a, 41a) zugeordneten Pixel (16b) der Anzeigefläche (16a) verbunden sind.

3. Testsystem nach Anspruch 2, wobei die Mehrzahl von, auf einer jeweiligen Leiterplatte (20a, 20b, 20c) angeordneten Digital-Analog-Wandler (22a-22n, 24a-n, 26a-n) durch einen auf der jeweiligen Leiterplatte (20a, 20b, 20c) oder außerhalb der jeweiligen Leiterplatte (20a, 20b, 20c) angeordneten integrierten Schaltkreis (40a, 40b, 40c), insbesondere einen FPGA, ansteuerbar sind.

4. Testsystem nach Anspruch 3, wobei der integrierte Schaltkreis (40a, 40b, 40c), insbesondere das FPGA, mit einem Eingang jedes der Mehrzahl von Digital-Analog-Wandlern (22a-22n, 24a-n, 26a-n) verbunden ist.

5. Testsystem nach Anspruch 4, wobei der aggregierte Cluster (18) von Pixeln (16b) gleicher Intensität (I) unabhängig von einer Form und/oder einer zeitlichen Verzögerung von innerhalb eines Meßzyklus des zu testenden LiDAR-Sensors (10) auf der Anzeigefläche (16a) dargestellten Objekten (42a, 42b, 42c) ist, und wobei die zu dem Cluster (18) aggregierten Pixel (16b) Leuchtelementen (36a-z, 37a, 41a) einer Mehrzahl von Leiterplatten (20a, 20b, 20c) zuordbar sind.

6. Testsystem nach einem der Ansprüche 2 bis 5, wobei jeder Eingang eines Crosspoint-Schalters (28a-n, 30a-n, 32a-n) auf eine Mehrzahl von Ausgängen des Crosspoint-Schalters (28a-n, 30a-n, 32a-n) aufschaltbar ist, wobei jeder Digital-Analog-Wandler (22a-22n, 24a-n, 26a-n) dazu eingerichtet ist, jedes Leuchtelement (36a-z, 37a, 41a) anzusteuern.

7. Testsystem nach einem der vorhergehenden Ansprüche, wobei jeder auf der Anzeigefläche (16a) der Signalerzeugungseinheit (16) erzeugte Cluster (18) von Meßzyklus zu Meßzyklus des zu testenden LiDAR-Sensors (10) in dessen Größe und Positionierung auf der Anzeigefläche (16a) der Signalerzeugungseinheit (16) anpassbar ist.

8. Testsystem nach einem der vorhergehenden Ansprüche, wobei ein auf der Anzeigefläche (16a) der Signalerzeugungseinheit (16) dargestelltes Objekt (42a, 42b, 42c) in eine Mehrzahl von Clustern (18) aufteilbar ist, und wobei die Anzeigefläche (16a) der Signalerzeugungseinheit (16) eine mit einem vorgegebenen Radius gekrümmte Fläche aufweist.

9. Testsystem nach einem der vorhergehenden Ansprüche, wobei auf der Anzeigefläche (16a) der Signalerzeugungseinheit (16) in einem Messzyklus dargestellte, unterschiedliche Intensitäten (I) aufweisende und hintereinander liegende, überlappende Objekte (42a, 42b, 42c) zu einem Cluster (18) aggregierbar sind, wobei zwischen den Objekten (42a, 42b, 42c) bestehende Abstände durch Ausschalten der Pixel (16b) für eine vorgegebene Zeitdauer darstellbar sind.

10. Testsystem nach einem der vorhergehenden Ansprüche, wobei eine Pixelauflösung und/oder eine Anzahl darstellbarer Intensitätsabstufungen der Anzeigefläche (16a) der Signalerzeugungseinheit (16) zumindest einer Pixelauflösung und/oder einer Anzahl erfassbarer Intensitätsabstufungen des LiDAR-Sensors (10) entspricht.

11. Verfahren zum Testen eines LiDAR-Sensors (10), mit den Schritten:
Bereitstellen (S1) eines Trigger-Detektors (12) und eines mit dem Trigger-Detektor (12) verbundenen Signalgenerators (14),
Bereitstellen (S2) einer Anzeigefläche (16a) einer Signalerzeugungseinheit (16) des Signalgenerators (14) mit einer vorgegebenen Anzahl von Pixeln (16b);
Ansteuern (S3) des Signalgenerators (14) durch den Trigger-Detektor (12) in Reaktion auf den Empfang eines Signals eines zu testenden LiDAR-Sensors (10) derart, dass durch die Signalerzeugungseinheit (16) des Signalgenerators (14) ein vorgegebenes, synthetisch erzeugtes, optisches Signal, insbesondere eine synthetisch erzeugte Reflexion eines LiDAR-Sensorsignals, ausgegeben wird; und Aggregieren (S4) von Pixeln (16b) gleicher Intensität (I) zu einem Cluster (18) durch den Signalgenerator (14), **dadurch gekennzeichnet dass** der Signalgenerator (14) eine Mehrzahl von Leiterplatten (20a, 20b, 20c) aufweist, auf denen jeweils eine Mehrzahl von Digital-Analog-Wandlern (22a-22n, 24a-n, 26a-n) angeordnet sind,
wobei jeder der Mehrzahl von Digital-Analog-Wandlern (22a-22n, 24a-n, 26a-n) mit einem Eingang einer Mehrzahl von Crosspoint-Schaltern (28a-n, 30a-n, 32a-n) verbunden wird,
wobei jeweilige Ausgänge der Mehrzahl von Crosspoint-Schaltern (28a-n, 30a-n, 32a-n) mit einem ein Leuchtelement (36a-z, 37a, 41a) der Signalerzeugungseinheit (16),
insbesondere eine Leuchtdiode oder eine Laserdiode, ansteuernden Leuchtelement-Treiber (34a-z, 35a, 39a) verbunden werden,
wobei die Anzahl von Leuchtelementen (36a-z, 37a, 41a) jeder Leiterplatte (20a, 20b, 20c) größer als die Anzahl von Digital-Analog-Wandlern (22a-22n, 24a-n, 26a-n) ist,
wobei die zwischen den Digital-Analog-Wandlern (22a-22n, 24a-n, 26a-n) und den Leuchtelement-Treibern (34a-z, 35a, 39a) der Leuchtelemente (36a-z, 37a, 41a) angeordneten Crosspoint-Schalter (28a-n, 30a-n, 32a-n) eine dynamisch einstellbare, koordinatenweise Verbindung zwischen den Digital-Analog-Wandlern (22a-22n, 24a-n, 26a-n) und den Leuchtelementen (36a-z, 37a, 41a) bereitstellen.

## Claims

1. A test system (1) for a LiDAR sensor (10), having a trigger detector (12) and a signal generator (14) connected to the trigger detector (12),
wherein the signal generator (14) is actuated by the trigger detector (12) in response to the reception of a trigger signal (TS) of a LiDAR sensor (10) to be tested in such a way that a signal generating unit (16) of the signal generator (14) outputs a specified, synthetically generated optical signal (RTS), in particular a synthetically generated reflection of the trigger signal (TS),
wherein the signal generation unit (16) comprises a display surface (16a) having a specified number of pixels (16b), and wherein the signal generator (14) is configured to aggregate pixels (16b) of the same intensity (I) to form a cluster (18),
**characterized in that**
the signal generator (14) comprises a plurality of printed circuit boards (20a, 20b, 20c) on each of which a plurality of digital-to-analog converters (22a-22n, 24a-n, 26a-n) are disposed,
each of the plurality of digital-to-analog converters (22a-22n, 24a-n, 26a-n) being connected to an input of a plurality of crosspoint switches (28a-n, 30a-n, 32a-n),
wherein respective outputs of the plurality of crosspoint switches (28a-n, 30a-n, 32a-n) are connected to a luminous element driver (34a-z, 35a, 39a) actuating a luminous element (36a-z, 37a, 41a) of the signal generating unit (16), in particular a light emitting diode or a laser diode,
wherein the quantity of luminous elements (36a-z, 37a, 41a) of each printed circuit board (20a, 20b, 20c) is greater than the quantity of digital-to-analog converters (22a-22n, 24a-n, 26a-n), wherein the crosspoint switches (28a-n, 30a-n, 32an) disposed between the digital-to-analog converters (22a-22n, 24a-n, 26a-n) and the luminous element drivers (34a-z, 35a, 39a) of the luminous elements (36a-z, 37a, 41a) are implemented for providing a dynamically adjustable, coordinate-wise connection between the digital-to-analog converters (22a-22n, 24a-n, 26a-n) and the luminous elements (36a-z, 37a, 41a) .

2. The test system according to claim 1, wherein respective luminous elements (36a-z, 37a, 41a) of the signal generating unit (16) of each of the plurality of printed circuit boards (20a, 20b, 20c) are connected via optical fibers (38a, 38b, 38c, 38d) to a pixel (16b) of the display surface (16a) associated with the respective luminous element (36a-z, 37a, 41a).

3. The test system according to claim 2, wherein the plurality of digital-to-analog converters (22a-22n, 24a-n, 26a-n) disposed on a respective printed circuit board (20a, 20b, 20c) can be controlled by an integrated circuit (40a, 40b, 40c), in particular an FPGA, disposed on the respective printed circuit board (20a, 20b, 20c) or outside the respective printed circuit board (20a, 20b, 20c).

4. The test system according to claim 3, wherein the integrated circuit (40a, 40b, 40c), in particular the FPGA, is connected to an input of each of the plurality of digital-to-analog converters (22a-22n, 24a-n, 26a-n) .

5. The test system according to claim 4, wherein the aggregated cluster (18) of pixels (16b) of the same intensity (I) is independent of a shape and/or a time delay of objects (42a, 42b, 42c) displayed on the display surface (16a) within one measurement cycle of the LiDAR sensor (10) to be tested, and wherein the pixels (16b) aggregated to form the cluster (18) can be associated with luminous elements (36a-z, 37a, 41a) of a plurality of printed circuit boards (20a, 20b, 20c).

6. The test system according to any one of the claims 2 to 5, wherein each input of a crosspoint switch (28a-n, 30a-n, 32a-n) can be connected to a plurality of outputs of the crosspoint switch (28an, 30a-n, 32a-n), wherein each digital-to-analog converter (22a-22n, 24a-n, 26a-n) is configured to control each luminous element (36a-z, 37a, 41a).

7. The test system according to any one of the preceding claims, wherein each cluster (18) generated on the display surface (16a) of the signal generating unit (16) is adjustable in the size and positioning thereof on the display surface (16a) of the signal generating unit (16) from measurement cycle to measurement cycle of the LiDAR sensor (10) to be tested.

8. The test system according to any one of the preceding claims, wherein an object (42a, 42b, 42c) displayed on the display surface (16a) of the signal generating unit (16) can be divided into a plurality of clusters (18), and wherein the display surface (16a) of the signal generating unit (16) comprises a surface curved at a specified radius.

9. The test system according to any one of the preceding claims, wherein overlapping objects (42a, 42b, 42c) lying one behind the other and displayed on the display surface (16a) of the signal generating unit (16) in one measurement cycle and having different intensities (I) can be aggregated to form a cluster (18), wherein distances between the objects (42a, 42b, 42c) can be displayed by switching off the pixels (16b) for a specified period of time.

10. The test system according to any one of the preceding claims, wherein a pixel resolution and/or a quantity of displayable intensity gradations of the display surface (16a) of the signal generating unit (16) corresponds to at least one pixel resolution and/or quantity of detectable intensity gradations of the LiDAR sensor (10).

11. A method for testing a LiDAR sensor (10), having the steps of:
providing (S1) a trigger detector (12) and a signal generator (14) connected to the trigger detector (12),
providing (S2) a display surface (16a) of a signal generating unit (16) of the signal generator (14) having a specified number of pixels (16b);
actuating (S3) the signal generator (14) by the trigger detector (12) in response to the reception of a signal from a LiDAR sensor (10) to be tested in such a way that a specified, synthetically generated optical signal, in particular a synthetically generated reflection of a LiDAR sensor signal, is output by the signal generating unit (16) of the signal generator (14); and
aggregating (S4) pixels (16b) of the same intensity (I) to form a cluster (18) by the signal generator (14),
**characterized in that**
the signal generator (14) comprises a plurality of printed circuit boards (20a, 20b, 20c) on each of which a plurality of digital-to-analog converters (22a-22n, 24a-n, 26a-n) are disposed,
wherein each of the plurality of digital-to-analog converters (22a-22n, 24a-n, 26a-n) is connected to an input of a plurality of crosspoint switches (28an, 30a-n, 32a-n),
wherein respective outputs of the plurality of crosspoint switches (28a-n, 30a-n, 32a-n) are connected to a luminous element driver (34a-z, 35a, 39a) actuating a luminous element (36a-z, 37a, 41a) of the signal generating unit (16), in particular a light emitting diode or a laser diode,
wherein the quantity of luminous elements (36a-z, 37a, 41a) of each printed circuit board (20a, 20b, 20c) is greater than the quantity of digital-to-analog converters (22a-22n, 24a-n, 26a-n),
wherein the crosspoint switches (28a-n, 30a-n, 32an) disposed between the digital-to-analog converters (22a-22n, 24a-n, 26a-n) and the luminous element drivers (34a-z, 35a, 39a) of the luminous elements (36a-z, 37a, 41a) provide a dynamically adjustable, coordinate-wise connection between the digital-to-analog converters (22a-22n, 24a-n, 26a-n) and the luminous elements (36a-z, 37a, 41a).

## Revendications

1. Système de test (1) pour un capteur LiDAR (10), comprenant
un détecteur de déclenchement (12) et un générateur de signaux (14) relié au détecteur de déclenchement (12), le générateur de signaux (14) étant commandé par le détecteur de déclenchement (12) en réaction à la réception d'un signal de déclenchement (TS) d'un capteur LiDAR (10) à tester de telle sorte qu'un signal optique (RTS) prédéfini généré de manière synthétique, en particulier une réflexion générée de manière synthétique du signal de déclenchement (TS), est délivré par une unité de génération de signaux (16) du générateur de signaux (14), l'unité de génération de signaux (16) possédant une surface d'affichage (16a) avec un nombre prédéfini de pixels (16b), et le générateur de signaux (14) étant conçu pour agréger des pixels (16b) de même intensité (I) en une grappe (18),
**caractérisé en ce que**
le générateur de signaux (14) possède une pluralité de cartes de circuit imprimé (20a, 20b, 20c) sur lesquelles sont respectivement disposés une pluralité de convertisseurs numérique-analogique (22a-22n, 24a-n, 26a-n), chacun de la pluralité de convertisseurs numérique-analogique (22a-22n, 24a-n, 26a-n) étant connecté à une entrée d'une pluralité de commutateurs à points de croisement (28a-n, 30an, 32a-n), des sorties respectives de la pluralité de commutateurs à points de croisement (28a-n, 30an, 32a-n) étant reliées à un circuit de pilotage d'élément lumineux (34a-z, 35a, 39a) qui commande un élément lumineux (36a-z, 37a, 41a) de l'unité de génération de signaux (16), en particulier une diode électroluminescente ou une diode laser, le nombre d'éléments lumineux (36a-z, 37a, 41a) de chaque carte de circuit imprimé (20a, 20b, 20c) étant supérieur au nombre de convertisseurs numérique-analogique (22a-22n, 24a-n, 26a-n), les commutateurs à point de croisement (28a-n, 30a-n, 32a-n) disposés entre les convertisseurs numérique-analogique (22a-22n, 24a-n, 26a-n) et les circuits de pilotage d'élément lumineux (34a-z, 35a, 39a) des éléments lumineux (36a-z, 37a, 41a) étant configurés pour fournir une liaison par coordonnées réglable dynamiquement entre les convertisseurs numérique-analogique (22a-22n, 24a-n, 26a-n) et les éléments lumineux (36a-z, 37a, 41a).

2. Système de test selon la revendication 1, dans lequel des éléments lumineux (36a-z, 37a, 41a) respectifs de l'unité de génération de signaux (16) de chacune de la pluralité de cartes de circuits imprimés (20a, 20b, 20c) sont reliés par des fibres optiques (38a, 38b, 38c, 38d) à un pixel (16b) de la surface d'affichage (16a) associé à l'élément lumineux (36a-z, 37a, 41a) respectif.

3. Système de test selon la revendication 2, dans lequel la pluralité de convertisseurs numérique-analogique (22a-22n, 24a-n, 26a-n) disposés sur une carte de circuit imprimé (20a, 20b, 20c) respective peuvent être commandés par un circuit intégré (40a, 40b, 40c), en particulier un FPGA, disposé sur la carte de circuit imprimé (20a, 20b, 20c) respective ou en dehors de la carte de circuit imprimé (20a, 20b, 20c) respective.

4. Système de test selon la revendication 3, dans lequel le circuit intégré (40a, 40b, 40c), en particulier le FPGA, est connecté à une entrée de chacun de la pluralité de convertisseurs numérique-analogique (22a-22n, 24a-n, 26a-n).

5. Système de test selon la revendication 4, dans lequel la grappe (18) agrégée de pixels (16b) de même intensité (I) est indépendant d'une forme et/ou d'un retard temporel d'objets (42a, 42b, 42c) représentés sur la surface d'affichage (16a) pendant un cycle de mesure du capteur LiDAR (10) à tester, et dans lequel les pixels (16b) agrégés en la grappe (18) peuvent être associés à des éléments lumineux (36a-z, 37a, 41a) d'une pluralité de cartes de circuits imprimés (20a, 20b, 20c).

6. Système de test selon l'une quelconque des revendications 2 à 5, dans lequel chaque entrée d'un commutateur à point de croisement (28a-n, 30a-n, 32a-n) peut être connectée à une pluralité de sorties du commutateur à point de croisement (28a-n, 30a-n, 32a-n), chaque convertisseur numérique-analogique (22a-22n, 24a-n, 26a-n) étant conçu pour commander chaque élément lumineux (36a-z, 37a, 41a).

7. Système de test selon l'une quelconque des revendications précédentes, dans lequel chaque grappe (18) générée sur la surface d'affichage (16a) de l'unité de génération de signaux (16) peut être adaptée en taille et en positionnement sur la surface d'affichage (16a) de l'unité de génération de signaux (16) d'un cycle de mesure à l'autre du capteur LiDAR (10) à tester.

8. Système de test selon l'une quelconque des revendications précédentes, dans lequel un objet (42a, 42b, 42c) représenté sur la surface d'affichage (16a) de l'unité de génération de signaux (16) peut être divisé en une pluralité de grappes (18), et dans lequel la surface d'affichage (16a) de l'unité de génération de signaux (16) présente une surface incurvée avec un rayon prédéterminé.

9. Système de test selon l'une quelconque des revendications précédentes, dans lequel des objets (42a, 42b, 42c) se chevauchant, représentés sur la surface d'affichage (16a) de l'unité de génération de signaux (16) dans un cycle de mesure, présentant des intensités (I) différentes et disposés les uns derrière les autres, peuvent être agrégés en une grappe (18), des distances existant entre les objets (42a, 42b, 42c) pouvant être représentées en éteignant les pixels (16b) pendant une durée prédéfinie.

10. Système de test selon l'une quelconque des revendications précédentes, dans lequel une résolution en pixels et/ou un nombre de gradations d'intensité représentables de la surface d'affichage (16a) de l'unité de génération de signaux (16) correspond à au moins une résolution en pixels et/ou un nombre de gradations d'intensité détectables du capteur LiDAR (10).

11. Procédé pour tester un capteur LiDAR (10), comprenant les étapes suivantes :
fournir (S1) un détecteur de déclenchement (12) et un générateur de signaux (14) connecté au détecteur de déclenchement (12),
fournir (S2) une surface d'affichage (16a) d'une unité de génération de signaux (16) du générateur de signaux (14) avec un nombre prédéterminé de pixels (16b) ;
commander (S3) le générateur de signaux (14) par le détecteur de déclenchement (12) en réponse à la réception d'un signal d'un capteur LiDAR (10) à tester, de telle sorte qu'un signal optique prédéterminé, généré de manière synthétique, en particulier une réflexion générée de manière synthétique d'un signal de capteur LiDAR, soit délivré par l'unité de génération de signaux (16) du générateur de signaux (14) ; et
agréger (S4) des pixels (16b) de même intensité (I) en une grappe (18) par le générateur de signaux (14),
**caractérisé en ce que**
le générateur de signaux (14) comprend une pluralité de cartes de circuits imprimés (20a, 20b, 20c) sur lesquelles sont respectivement disposés une pluralité de convertisseurs numérique-analogique (22a-22n, 24a-n, 26a-n),
dans lequel chacun de la pluralité de convertisseurs numérique-analogique (22a-22n, 24a-n, 26a-n) est connecté à une entrée d'une pluralité de commutateurs à point de croisement (28a-n, 30a-n, 32a-n),
dans lequel des sorties respectives de la pluralité de commutateurs à point de croisement (28a-n, 30a-n, 32a-n) sont reliées à un circuit de pilotage (34a-z, 35a, 39a) d'élément lumineux commandant un élément lumineux (36a-z, 37a, 41a) de l'unité de génération de signaux (16), en particulier une diode électroluminescente ou une diode laser,
dans lequel le nombre d'éléments lumineux (36a-z, 37a, 41a) de chaque carte de circuit imprimé (20a, 20b, 20c) est supérieur au nombre de convertisseurs numérique-analogique (22a-22n, 24a-n, 26a-n),
dans lequel les commutateurs à point de croisement (28a-n, 30a-n, 32a-n) disposés entre les convertisseurs numérique-analogique (22a-22n, 24a-n, 26a-n) et les circuits de pilotage (34a-z, 35a, 39a) d'éléments lumineux des éléments lumineux (36a-z, 37a, 41a) fournissent une liaison par coordonnées réglable dynamiquement entre les convertisseurs numérique-analogique (22a-22n, 24a-n, 26a-n) et les éléments lumineux (36a-z, 37a, 41a).
